Europäisches Patentamt

European Patent Office

Office européen des brevets

(11) Veröffentlichungsnummer: **0 129 729**
**A2**

(12) **EUROPÄISCHE PATENTANMELDUNG**

(21) Anmeldenummer: **84106036.1**

(22) Anmeldetag: **28.05.84**

(51) Int. Cl.⁴: **G 03 F 7/02**

(30) Priorität: **18.06.83 DE 3322011**

(43) Veröffentlichungstag der Anmeldung:
**02.01.85 Patentblatt 85/1**

(84) Benannte Vertragsstaaten:
**AT BE CH DE FR GB IT LI LU NL SE**

(71) Anmelder: **Continental Gummi-Werke
Aktiengesellschaft
Königsworther Platz 1
D-3000 Hannover 1(DE)**

(72) Erfinder: **Bartholmei, Peter, Dipl.-Chem.
Neustädter Ring 9a
D-3410 Northeim(DE)**

(72) Erfinder: **Spöring, Günter, Dipl. Ing.
Leharweg 8
D-3410 Northeim(DE)**

(72) Erfinder: **Lotts, William
Am Mühlenanger
D-3410 Northeim(DE)**

(54) **Verfahren zur Herstellung von Hochdruckformen.**

(57) Die Erfindung bezieht sich auf ein Verfahren zur Herstellung von Hochdruckformen, insbesondere von flexiblen Druckplatten oder zylindrischen Formen für den Hockdruck, mit einer Trägerschicht und wieterhin mit einer elastischen Deckschicht aus Gummi oder Kunststoff. Es wird erfindungsgemäß vorgeschlagen, daß ein Druckmotiv durch Aufrasterung in elektronische Signale umgewandelt wird, daß die elektronischen Signale eine Elektronenstrahlvorrichtung steuern, daß mittels der Elektronenstrahlen dieser Vorrichtung die druckenden Stellen der Deckschicht bestrahlt und vernetzt werden und daß danach das Material an den nicht vernetzten Stellen der Deckschicht mittels geeigneter Materialien entfernt wird.

Fig. 1

EP 0 129 729 A2

Verfahren zur Herstellung von Hochdruckformen

Die Erfindung betrifft ein Verfahren zur Herstellung von Hochdruckformen, insbesondere von flexiblen Druckplatten oder zylindrischen
Formen für den Hochdruck,mit einer Trägerschicht und weiterhin
mit einer elastischen Deckschicht aus Gummi oder Kunststoff.

Bei bekannten Druckplatten und Druckwalzen für den Hochdruck, zu dem
bekanntlich auch der Flexodruck gezählt wird, stellt man das Reliefmotiv im wesentlichen nach folgenden Verfahren her: Bei einem
Klischee-Gummi erfolgt die Vernetzung des geprägten Motivs durch
Druck und Wärme. Die Fotopolymerisation zeichnet sich durch eine
Vernetzung der druckenden Reliefpartien mittels Licht verschiedener
Wellenlänge und durch Abtragung der nichtdruckenden Partien durch
Ätzen, Bürsten und Waschen aus. Bei Gravurplatten bzw. -zylindern
wird das Motiv auf vernetzten Platten bzw. Zylindern mit Hilfe von
Laserstrahlen oder mechanischen Gravurstiften eingraviert.

Alle diese bekannten Verfahren, bei denen das Druckmotiv über Fotopolymerplatten, Matern oder mühsame Gravuren erzeugt wird, weisen
den Nachteil einer großen Aufwendigkeit auf. Außerdem entstehen hohe
Kosten, sei es für die heute noch sehr teuren Fotopolymere, sei es
für die mit Druck und Wärme arbeitenden Vulkanisierformen.

Der Erfindung liegt deshalb die Aufgabe zugrunde, ein Verfahren zur
einfacheren und billigeren Herstellung von Hochdruckformen anzugeben.

Diese Aufgabe wird erfindungsgemäß dadurch gelöst, daß ein Druckmotiv
durch Aufrasterung in elektronische Signale umgewandelt wird, daß die elektronischen Signale eine Elektronenstrahlvorrichtung steuern, daß mittels der Elektronenstrahlen dieser Vorrichtung die druckenden Stellen der Deckschicht bestrahlt und vernetzt werden und daß danach das Material an den nicht vernetzten Stellen der Deckschicht mittels geeigneter Materialien entfernt wird.

Durch die Erfindung wird eine weitere, gegenüber den bekannten Verfahren sehr einfache Methode zur Erzeugung von Druckmotiven auf Hochdruckformen, zu denen insbesondere Druckplatten und zylindrische Formen gehören, zur Verfügung gestellt. Aufgrund der Umwandlung in elektronische Signale ist es auf einfache Weise möglich, ein Druckmotiv elektronisch abzuspeichern und jederzeit bei Bedarf wieder abzurufen. Die Verarbeitungs- und Speichertechnik kann mit Hilfe der aus der Fernseh- und Videotechnik bekannten Methoden durchgeführt werden. Weiterhin sind Elektronenstrahlvorrichtungen bekannt, die Elektronenstrahlen so hoher Intensität erzeugen, daß sie eine Vernetzung von Kautschukschichten bei Atmosphärendruck ermöglichen.

Grundsätzlich kann die Bestrahlung und Vernetzung einer Deckschicht aus Kautschuk oder Kunststoff in der Weise erfolgen, daß entweder die gesamte Fläche mit Elektronenstrahlen entsprechend dem Druckmotiv auf einmal bestrahlt wird oder daß die Elektronenstrahlen gleichsam zeilenweise über die Deckschicht gelenkt werden, so daß ein schmaler Streifen des Druckmotivs auf die Deckschicht gebracht wird, dem sich nach einem kurzen Vorschub der Druckform der nächste Streifen anschließt, u.s.w.

Nachfolgend wird anhand einer schematischen Zeichnung das erfindungsgemäße Verfahren näher erläutert.

Es zeigt:

Fig. 1 einen Teil einer Rohform mit einer Trägerschicht und einer Deckschicht in einem Schnitt,

Fig. 2 einen Teil einer Hochdruckform mit einem eingearbeiteten Motiv in einem Schnitt,

Fig. 3 eine andere Rohform, bei der die Trägerschicht
ausschließlich aus Gummi besteht, in einem Schnitt.

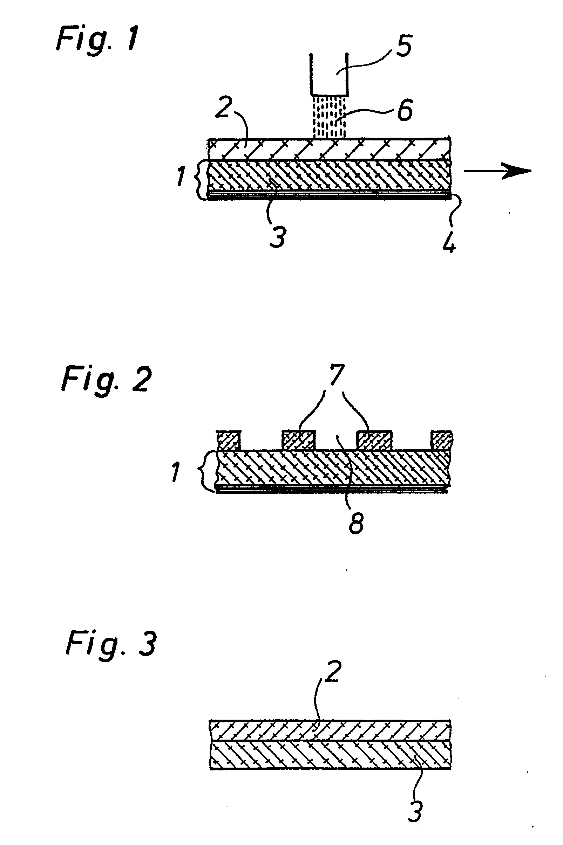

Die in Fig. 1 schematisch dargestellte Rohform, aus der eine Hochdruckform hergestellt werden soll, besteht aus einer Trägerschicht 1
und einer Deckschicht 2, wobei die Trägerschicht sich wiederum aus
einer Gummischicht 3 und einer Trägerfolie 4 aus Kunststoff zusammensetzt. Es sind jedoch auch Fälle denkbar, in denen die Trägerschicht 1
ausschließlich aus einer Gummischicht 3 (Fig. 3) oder ausschließlich
aus einer Folie besteht.

Die bei der fertigen Hochdruckform elastische Deckschicht 2 kann bei
der Rohform aus einer Kautschukmischung oder einem unvernetzten Kunststoff, z.B. Polyurethan bestehen. Als zu verwendende Kautschuke kommen
besonders solche in Frage, die aus einer Art Monomer oder aus einem
Mischpolymerisat aufgebaut sind; letztere können auch in Form eines
Blockpolymers vorliegen. Insbesondere sind Styrolbutadien und auch
Polyurethan geeignet. Die Mischungen enthalten neben üblichen Füll-
und Zusatzstoffen Vernetzungsaktivatoren, wie sie aus der peroxydischen
Vernetzung bekannt sind.

Mittels einer Elektronenstrahlvorrichtung 5 werden diejenigen Stellen
der Deckschicht 2 mit Elektronenstrahlen 6 bestrahlt, die das Positiv
des Druckmotivs darstellen sollen, d.h. die bei der fertigen Hochdruckform die erhabenen Stellen (Schrift und/oder Bild) für einen
Druckvorgang bilden. Dabei kann das Fenster der Elektronenstrahlvorrichtung 5 so groß gewählt sein, daß das gesamte Format des Druckmotivs auf einmal bestrahlt wird, es kann aber auch eine streifenweise
Bestrahlung unter diskontinuierlichem Vorschub der Rohform erfolgen.

Nach einer für eine Vernetzung ausreichenden Bestrahlung wird in
einem weiteren Verfahrensschritt die Deckschicht 2 mit einem Lösungsmittel beaufschlagt, das das Material an den nicht vernetzten Stellen
löst. Geeignete Lösungsmittel sind Äthylazetat, Toluol und Methyläthylketon. Nach dieser chemischen Behandlung kann das Deckschichtmaterial zwischen den vernetzten Stellen 7 durch Bürsten, Waschen und Trocknen oder auf sonstige Weise entfernt werden, und es entsteht die fertige Hochdruckform mit dem Druckmotiv in Form von erhabenen (druckenden) Stellen 7 und Vertiefungen 8.

Das aufgezeigte Verfahren eignet sich grundsätzlich auch für einen Einsatz zur Herstellung von Tiefdruckformen. Abweichend von der vorstehenden Beschreibung müssen dann lediglich die nichtdruckenden Stellen der Deckschicht mittels Elektronenstrahlen vernetzt werden, während das Deckschichtmaterial an den druckenden Stellen entfernt wird.

Es sollte angemerkt werden, daß unter die beschriebenen Verfahren selbstverständlich auch eine Ausführungsform fallen soll, bei der eine Trägerschicht nicht als separate Schicht eingesetzt wird, sondern durch Vor- oder teilweises Vulkanisieren der Deckschicht von unten erzeugt wird.

Ansprüche

1. Verfahren zur Herstellung von Hochdruckformen, insbesondere von flexiblen Druckplatten oder zylindrischen Formen für den Hochdruck, mit einer Trägerschicht und weiterhin mit einer elastischen Deckschicht aus Gummi oder Kunststoff, dadurch gekennzeichnet, daß ein Druckmotiv durch Aufrasterung in elektronische Signale umgewandelt wird, daß die elektronischen Signale eine Elektronenstrahlvorrichtung steuern, daß mittels der Elektronenstrahlen dieser Vorrichtung die druckenden Stellen der Deckschicht bestrahlt und vernetzt werden und daß danach das Material an den nicht vernetzten Stellen der Deckschicht mittels geeigneter Materialien entfernt wird.

2. Verfahren nach Anspruch 1, dadurch gekennzeichnet, daß für die Deckschicht ein Kautschuk eingesetzt wird, der aus einem einzigen Monomer oder aus einem Mischpolymerisat aufgebaut ist.

3. Verfahren nach den Ansprüchen 1 und/oder 2, dadurch gekennzeichnet, daß für die Deckschicht ein Kautschuk eingesetzt wird, der aus einem Blockpolymer besteht.

4. Verfahren nach den Ansprüchen 1, 2 oder 3, dadurch gekennzeichnet, daß für die Deckschicht Styrolbutadien eingesetzt wird.

5. Verfahren nach Anspruch 1, dadurch gekennzeichnet, daß für die Deckschicht Polyurethan eingesetzt wird.

6. Verfahren nach Anspruch 1, dadurch gekennzeichnet, daß nach dem Vernetzen der das Positiv des Druckmotivs bildenden Stellen der Deckschicht das Material der übrigen Stellen durch chemische und/oder mechanische Mittel gelöst und entfernt wird.

7. Verfahren nach Anspruch 6, dadurch gekennzeichnet, daß als chemisches Lösungsmittel Äthylazetat, Toluol oder Methyläthylketon eingesetzt werden.

8. Verfahren nach Anspruch 1, dadurch gekennzeichnet, daß dem Material der Deckschicht als Vernetzungskomponente Aktivatoren beigegeben werden, die bei der peroxydischen Vernetzung eingesetzt werden.

9. Verfahren nach Anspruch 1, dadurch gekennzeichnet, daß die Trägerschicht aus einer Gummischicht und/oder einer Kunststoffolie aufgebaut wird.

10. Verfahren zur Herstellung von Tiefdruckformen, insbesondere von flexiblen zylindrischen Formen für den Tiefdruck, mit einer Trägerschicht und weiterhin mit einer elastischen Deckschicht aus Gummi oder Kunststoff, dadurch gekennzeichnet, daß ein Druckmotiv durch Aufrasterung in elektronische Signale umgewandelt wird, daß die elektronischen Signale eine Elektronenstrahlvorrichtung steuern, daß mittels der Elektronenstrahlen dieser Vorrichtung die nicht druckenden Stellen der Deckschicht bestrahlt und vernetzt werden und daß danach das Material an den nicht vernetzten Stellen der Deckschicht mittels geeigneter Materialien entfernt wird.

Hannover, den 13. Juni 1983
Sr/Fr             83-26 P/Sr

*Fig. 1*

*Fig. 2*

*Fig. 3*

Continental
Gummi – Werke AG